# FASCICULE DE BREVET EUROPEEN

(11) **EP 2 383 775 B1**
(45) Date de publication et mention de la délivrance du brevet: **15.03.2017**
(21) Numéro de dépôt: 11163944.9
(22) Date de dépôt: 27.04.2011
(51) Int. Cl.: H01L 21/311, H01L 41/22

(54) **Procédé pour obtenir une couche d'AlN à flancs sensiblement verticaux**
Method for obtaining a layer of AlN with substantially vertical flanks
Verfahren zum Erhalten einer AlN-Schicht mit deutlich vertikalen Flanken

(30) Priorité: 30.04.2010 FR 1053360
(43) Date de publication de la demande: 02.11.2011
(73) Titulaire: Commissariat à l'Énergie Atomique et aux Énergies Alternatives, 75015 Paris (FR)
(72) Inventeur: Aid, Marc, 38000, Grenoble (FR); Defay, Emmanuel, 38340, Voreppe (FR); Lefevre, Aude, 38190, Froges (FR); Parat, Guy-Michel, 38640, Claix (FR)
(74) Mandataire: Ilgart, Jean-Christophe

(56) Documents cités:
- JP-A- 2002 240 271
- US-A1- 2006 046 319
- US-B1- 6 306 313
- GIANLUCA PIAZZA ET AL: "Piezoelectric Aluminum Nitride Vibrating Contour-Mode MEMS Resonators", JOURNAL OF MICROELECTROMECHANICAL SYSTEMS, IEEE SERVICE CENTER, US, vol. 15, no. 6, 1 décembre 2006 (2006-12-01), pages 1406-1418, XP011151359, ISSN: 1057-7157, DOI: 10.1109/JMEMS.2006.886012
- ABABNEH A ET AL: "Etching behaviour of sputter-deposited aluminium nitride thin films in H3PO4 and KOH solutions", MICROSYSTEM TECHNOLOGIES, BERLIN, DE, vol. 14, no. 4-5, 30 avril 2008 (2008-04-30), pages 567-573, XP002620193, ISSN: 0946-7076, DOI: 10.1007/S00542-007-0450-X [extrait le 2008-01-29]

## Description

### DOMAINE TECHNIQUE ET ART ANTÉRIEUR

L'invention concerne des techniques de gravure d'un matériau tel que l'AlN, en vue de réaliser une couche de ce matériau avec un ou des flancs droits, c'est-à-dire sensiblement perpendiculaires à une surface sur laquelle cette couche est déposée ou formée. On entend par « sensiblement perpendiculaire » le fait que le flanc fasse avec ladite surface un angle supérieur ou égal à 75°.

Ce type de matériau est mis en oeuvre dans la réalisation de composants MEMS, par exemple du type requérant une couche piézoélectrique ou diélectrique à flancs droits.

On en fait usage également dans la préparation de résonateurs acoustiques. Un tel résonateur comporte une couche piézoélectrique qui doit avoir un ou des flancs verticaux, afin d'empêcher la propagation d'ondes parasites.

Enfin, ce type de matériau est aussi mis en oeuvre dans la réalisation de MEMS à détection capacitive, qui nécessitent des « gap » fins et verticaux, ou encore dans la réalisation de gyroscopes.

L'article de G. Piazza, paru dans Journal of Microelectromechanical Systems, volume 15, numéro 6, page 1406-1418, intitulé «Piezoelectric Aluminium Nitride Vibrating Contour-Mode MEMS Resonators », 2006, décrit notamment la mise en oeuvre de l'AIN dans un résonateur MEMS.

Cependant, à l'heure actuelle, on ne connaît pas de technique permettant de graver l'AIN avec des flancs droits.

Les techniques de gravure sèche ou humide présentent toutes un caractère isotrope. Elles résultent en un ou des flancs ne présentant pas le caractère de verticalité souhaité: le matériau est en effet alors gravé suivant une direction verticale, mais aussi suivant une direction horizontale.

Il se pose donc le problème de trouver une technique de réalisation d'une couche d'AIN avec un flanc droit, c'est-à-dire sensiblement perpendiculaire à un substrat sur lequel la couche est réalisée.

### EXPOSÉ DE L'INVENTION

L'invention concerne d'abord un procédé de réalisation d'une couche d'AlN à au moins un flanc sensiblement vertical ou perpendiculaire par rapport à une surface d'un substrat, conformément à la revendication 1.

Le motif de type marche définit une partie surélevée du motif par rapport à un niveau inférieur. Le dépôt de la couche d'AlN est réalisé sur la partie surélevée et sur le niveau inférieur.

On entend par « sensiblement vertical perpendiculaire » le fait que le flanc fasse avec ladite surface un angle supérieur ou égal à 75°.

Un tel procédé peut comporter une étape préalable de formation de la topologie du substrat, par gravure de la surface du substrat, de manière à obtenir au moins le motif de type marche.

La marche peut présenter au moins un flanc latéral formant un angle au plus égal à 15° par rapport à la perpendiculaire à la surface du substrat dans ou sur lequel elle est réalisée.

Selon un mode de réalisation particulier, le substrat comporte une sous-couche, dont une surface forme, avec la surface du substrat, le motif de type marche. Cette sous-couche peut être obtenue par dépôt d'une couche uniforme de matériau, puis gravure au moins de cette couche, pour obtenir le motif de type marche.

Au moins une partie de la sous-couche et/ou au moins une partie de la couche de masque peut former une électrode.

Un procédé selon l'invention peut en outre comporter la réalisation d'un flanc incliné par gravure de la couche d'AlN.

La gravure de la couche d'AIN est de type gravure humide.

Un procédé selon l'invention peut en outre permettre de réaliser au moins un trou à bords verticaux, le diamètre du trou et l'épaisseur de la couche d'AlN ayant préférentiellement un rapport diamètre/épaisseur inférieur à 0,5.

La topologie peut résulter d'une gravure de la surface du substrat de manière à obtenir au moins le motif de type marche.

La marche peut présenter au moins un flanc latéral formant un angle au plus égal à 15° par rapport à la perpendiculaire à la surface du substrat dans ou sur lequel elle est réalisée.

Le substrat peut comporter une sous-couche, dont une surface forme, avec la surface du substrat, le motif de type marche.

La sous couche peut être formée au moins en partie sur une couche formant une topologie en surface du substrat support.

Dans un procédé ou un dispositif selon l'invention :
- la sous-couche peut être en titane (Ti) ou en silicium (Si), ou en molybdène (Mo), ou en platine (Pt), ou en nitrure de silicium ;
- et/ou la topologie ou le motif de type marche ou la sous-couche peut avoir une épaisseur comprise entre 10 nm et 1 µm ;
- et/ou la couche de masque peut être en silice (SiO₂), ou en molybdène (Mo), ou en platine (Pt) ou en une résine adhérente ;
- et/ou la couche de masque a par exemple une épaisseur comprise entre 10 nm et 10 µm.

### BRÈVE DESCRIPTION DES DESSINS

- Les figures 1A à 1D représentent des étapes d'un procédé selon l'invention,
- les figures 2A et 2B représentent une variante d'un procédé selon l'invention,
- la figure 3 représente un agrandissement d'une partie d'un substrat sur lequel la variante des figures 2A et 2B peut être mise en oeuvre,
- la figure 4 représente un substrat obtenu par combinaison de deux modes de réalisation d'un procédé selon l'invention,
- les figures 5A - 5D représentent un autre mode de réalisation d'un procédé selon l'invention,
les figures 6A - 6D représentent encore un autre mode de réalisation d'un procédé selon l'invention.

### EXPOSÉ DÉTAILLÉ DE MODES DE RÉALISATION DE L'INVENTION

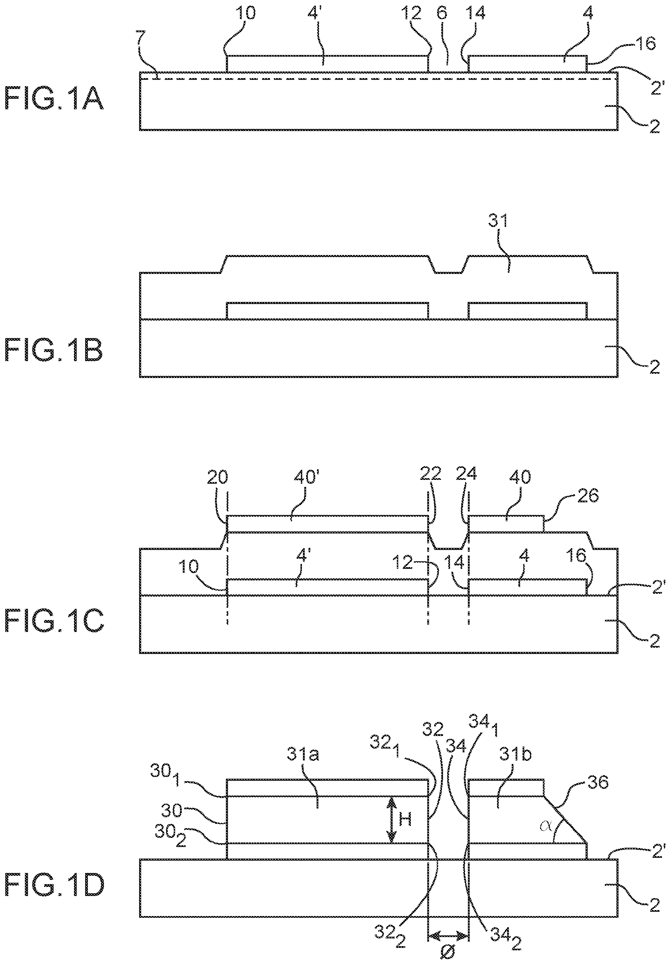

Un premier mode de réalisation de l'invention va être décrit en liaison avec les figures 1A à 1D.

Sur un substrat 2, par exemple en silicium ou en saphir, on forme, par exemple par dépôt, une couche 4, qui peut être continue ou connexe mais qui ne l'est pas nécessairement: dans l'exemple de la figure 1A, cette couche comporte une première partie 4 qui est séparée d'une deuxième partie 4' par une ouverture 6 qui laisse apparaître la surface 2' du substrat 2.

Cette ouverture est par exemple obtenue par gravure d'une couche initiale continue du matériau des parties 4,4', gravure qui s'arrête sur la surface 2' du substrat 2. Les références 12 et 14 désignent les flancs respectivement des portions 4' et 4 de cette couche, de part et d'autre de l'ouverture 6. Deux autres flancs sont désignés par les références 10 et 12, à gauche et à droite de la figure 1A.

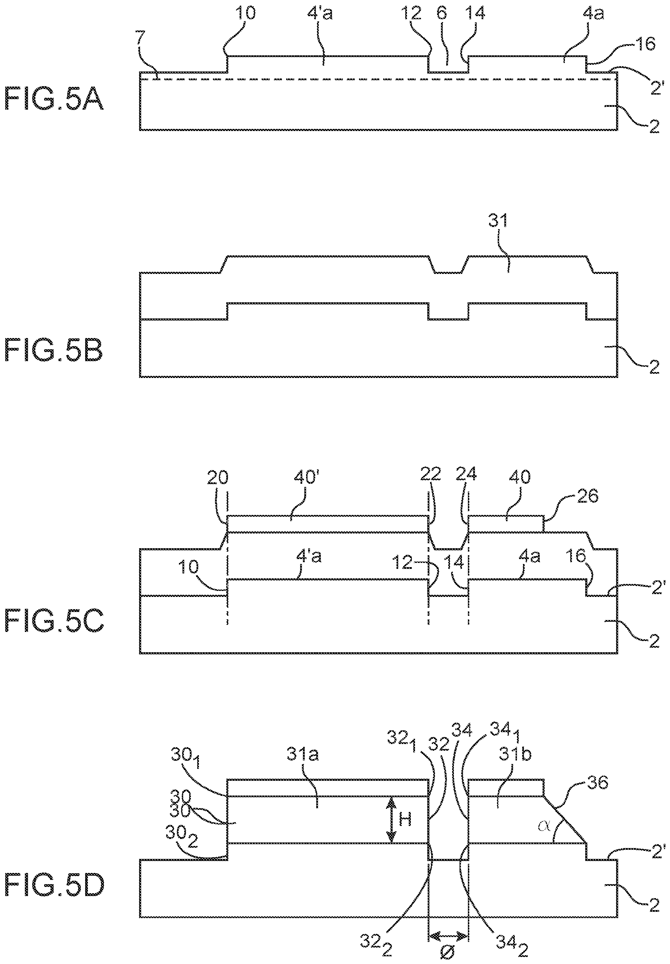

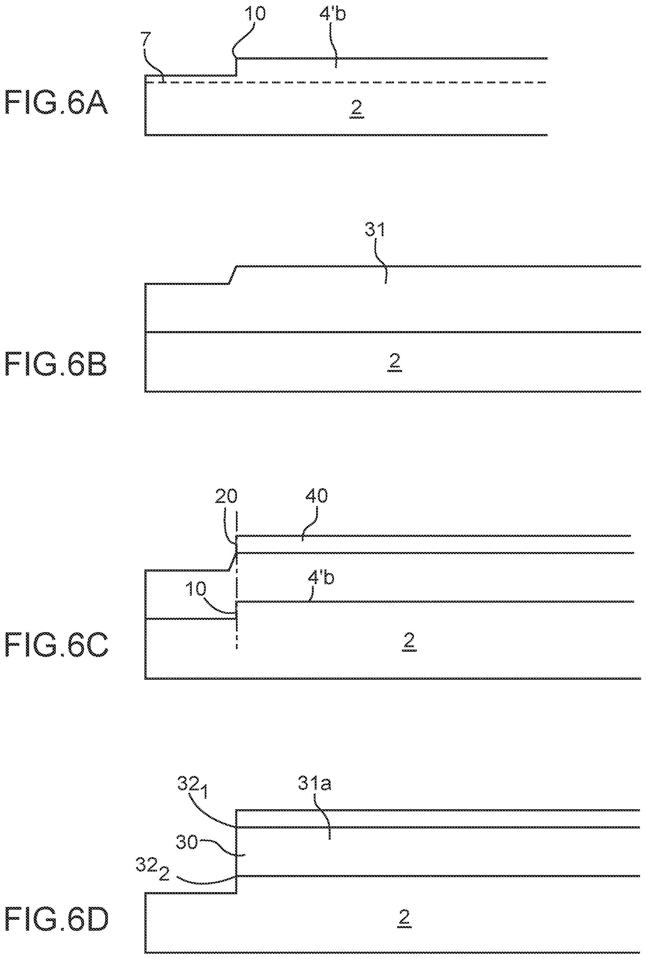

Autrement dit, cette couche 4, 4', de même que la topologie 4a, 4'a, 4b formée dans les modes de réalisation des figures 5A-5D et 6A-6D, est bordée ou entourée d'une surface 2' du substrat située à un niveau inférieur par rapport au niveau supérieur ou à la partie surélevée de la couche 4, 4' ou de la topologie 4a, 4'a, 4b.

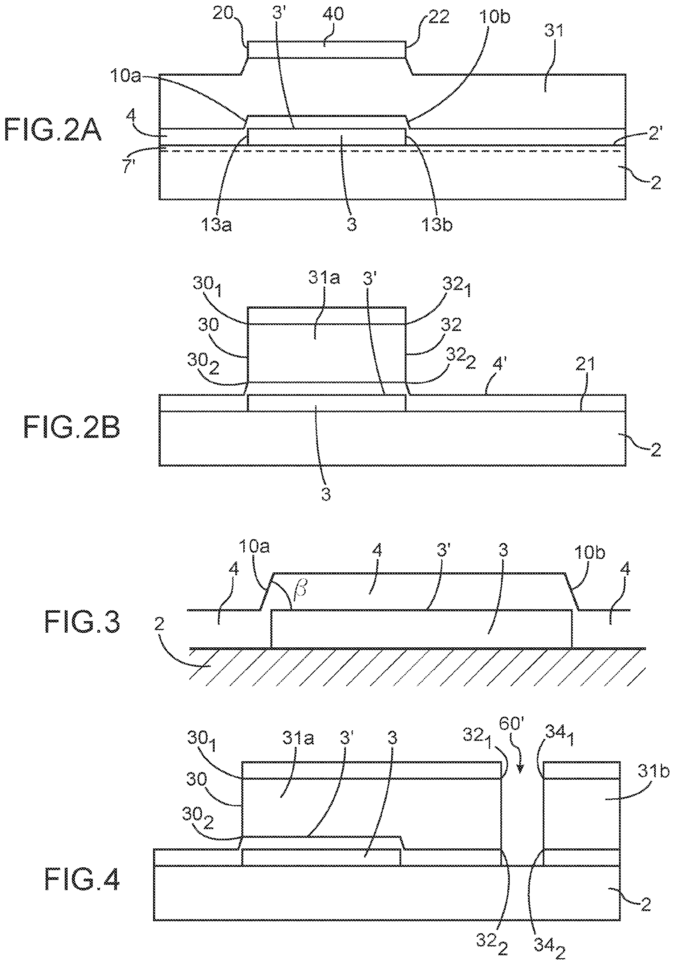

Dans le cas des figures 2A-2B, c'est une partie surélevée de la couche 4 (la partie de cette couche qui est sur la couche 3) qui est bordée ou entourée d'une partie non surélevée de cette même couche 4 (la partie de cette couche 4 qui est directement sur le substrat 2).

Tous ces flancs 10, 12, 14, 16 sont droits, c'est-à-dire sensiblement perpendiculaires à la surface 2' du substrat 2 ou forment avec la perpendiculaire à cette surface un angle inférieur ou égal à 15°.

Le matériau de la couche 4, 4' est par exemple du titane (Ti) ou du silicium (Si), ou du molybdène (Mo), ou du platine (Pt), ou du nitrure de silicium (SiN ou Si₃N₄) ou encore de l'oxyde de silicium (SiO₂).

Cette couche 4, 4' peut avoir une épaisseur de l'ordre de 200 nm, ou, plus généralement, comprise entre 10 nm et 1 µm ou encore entre 100 nm et 300 nm.

Au moins une partie de cette couche 4, 4' peut former une électrode.

Eventuellement, une couche 7 de texturation ou de germination, qui permettra d'aider à l'orientation du matériau 31 qui sera ensuite déposé, peut avoir été préalablement formée en surface du substrat 2.

On procède ensuite (figure 1B) au dépôt d'une couche 31 d'AlN, par exemple d'épaisseur environ égale à 1 µm ou, plus généralement, comprise entre 10 nm et 5 µm. Une technique de dépôt pouvant être utilisée est la technique PVD («Physical Vapor Deposition »).

Cette couche 31 est déposée uniformément sur les portions 4, 4' de la couche obtenue précédemment (dite aussi sous-couche ou couche de topologie), ainsi que sur les parties de la surface 2' du substrat 2 qui sont mises à nu, ou encore à la fois sur le niveau inférieur défini par la couche 4, 4' sur la surface 2' et sur le niveau supérieur ou sur la partie surélevée de la couche 4, 4' (ou de la topologie 4a, 4'a, 4b dans les autres figures 5A - 6D).

On procède ensuite (figure 1C) sur la couche 31 à une étape de réalisation d'un masque dur 40, 40', dont les bords 20, 22, 24 sont alignés avec les bords 10, 12, 14 de la sous-couche 4, 4'. Là encore, une ou plusieurs parties de ce masque peut former une électrode, par exemple d'un dispositif non représenté sur les figures.

Autrement dit, ces bords 20, 22, 24 définissent avec, respectivement, chacun des bords 10, 12, 14 de la couche 4, 4' un plan qui est sensiblement perpendiculaire à la surface 2' du substrat 2. En fait, ce plan pourra ne pas être strictement perpendiculaire à la surface 2', mais être légèrement incliné par rapport à la direction perpendiculaire, par exemple d'un angle compris entre 0° et 15°. Cette couche de masque 40, 40' a une épaisseur qui peut être comprise par exemple entre 10 nm et 10 µm. Elle peut être par exemple en molybdène Mo ou en nitrure de silicium (SiN, Si₃N₄).

L'alignement des bords 20, 22, 24 avec, respectivement, chacun des bords 10, 12, 14 peut être obtenu avec une précision de l'ordre du µm ou de moins de 1 µm, par exemple une précision de ±1 µm sur un stepper 1X, ±150 nm pour des lithographies en UV profond (dites « deep uv ») et de ± 50 nm pour des lithographies de type « ebeam ».

Cet alignement va permettre de définir une extrémité haute 30₁, 32₁, 34₁ et une extrémité basse 30₂, 32₂, 34₂ des flancs 30, 32, 34 qui vont être réalisés dans la couche 31.

Les bords du masque 40, 40' vont définir les extrémités hautes 30₁, 32₁, 34₁ des flancs à graver (autrement dit, ces extrémités hautes sont positionnées là où sont positionnés les bords du masque).

De même, les bords de la couche 4, 4' vont définir les extrémités basses 30₂, 32₂, 34₂ des flancs à graver (autrement dit, ces extrémités basses sont positionnées là où sont positionnés les bords de cette couche).

Dans cet exemple, et comme on le voit sur la figure 1C, l'un des flancs du masque 40, ici le flanc droit 26, n'est, lui, pas aligné avec le flanc droit 16 de la sous-couche 4.

On procède ensuite à une étape de gravure, comme représenté en figure 1D. Cette étape va permettre de graver la couche 31 de matériau AlN, dans des zones qui ne sont pas protégées par le masque 40, 40'. Cette gravure est poursuivie jusqu'à la surface 2' du substrat 2, cette surface 2' réapparaît donc après que la gravure soit terminée.

La pente de chaque flanc, qui s'étend entre une extrémité haute 30₁, 32₁, 34₁ et une extrémité basse 30₂, 32₂, 34₂ et est définie par le couple correspondant d'extrémité haute et basse 30₁, 32₁, 34₁ et 30₂, 32₂, 34₂.

Du fait des conditions d'alignement des bords du masque 40, 40' avec ceux de la sous-couche 4, 4', on obtient des flancs 30, 32, 34, de la couche 31, alignés avec les flancs correspondant de la sous-couche 4, 4' et de la couche de masque 40, 40'.

Autrement dit, ces flancs 30, 32, 34 de la couche d'AIN 31, sont perpendiculaires à la surface 2' du substrat 2, ou leur inclinaison par rapport à cette perpendiculaire est inférieure à quelques degrés, par exemple inférieure à ±15°.

Dans l'exemple qui a été représenté sur les dessins, la gravure conduit à la formation d'un trou 60, entre deux portions 31a, 31b d'AIN qui sont situées sous les portions 40, 40' de masque dur.

Les parois de ce trou sont les flancs 32, 34 qui, comme indiqué ci-dessus, sont perpendiculaires à la surface 2' de la couche 2. Avec cette technique, il est possible d'obtenir un trou de diamètre 0 d'environ 10µm, plus généralement compris entre 100 nm et 100 µm et/ou un trou qui traverse la couche 31, et dont le rapport du diamètre Ø à l'épaisseur H de la couche est inférieur ou égal à environ ½ (Ø/H < 0,5).

Comme déjà indiqué ci-dessus, le flanc droit 26 de la couche de masque 40 n'est pas aligné avec le flanc droit 16 de la couche 4 de croissance.

Il en résulte donc un flanc 36 de la couche 31b qui n'est pas perpendiculaire à la surface 2' de substrat 2, mais définit, avec cette surface 2', un angle α.

Un autre mode de réalisation va être expliqué, en liaison avec les figures 2A et 2B.

Sur ces figures, partant d'un substrat 2 identique à celui décrit précédemment, on forme d'abord une couche 3, d'épaisseur e, en vue de la création d'une topologie dans la future sous-couche 4 (ou, là encore, couche de topologie).

Cette couche 3 peut être par exemple une couche servant à définir une électrode. Elle est par exemple en SiO₂ ou en SiN ou en molybdène (Mo) ou en platine(Pt). Son épaisseur e est par exemple comprise entre 10 nm et 1 µm, ou entre 100 nm et 300 nm.

On peut préalablement réaliser, comme dans le premier mode, une sous-couche 7' de texturation. Cette sous-couche texture alors la couche 3, qui texture elle-même la couche 31.

On dépose ensuite une couche 4, dont la nature et l'épaisseur peuvent être celles déjà citées pour le premier mode de réalisation. On obtient donc, après ce dépôt, une couche 4 dont une partie repose directement sur la surface 2' du substrat 2, et dont une autre partie repose sur la surface 3' de la couche 3. Les bords 13a, 13b de la couche 3 se traduisent, dans la couche déposée 4, par des flancs 10a, 10b qui peuvent être légèrement inclinés par rapport à une direction perpendiculaire à la surface 2'. Cet aspect est représenté de manière plus détaillée en figure 3, où l'on voit que le flanc 10a définit, avec un plan horizontal (on prend ici comme référence la surface 3' de la couche 3) un angle β qui peut être de l'ordre de 80° ou plus.

On a donc, là encore, engendré une marche dans la couche 4, de hauteur sensiblement égale à l'épaisseur e de la couche 3. Les bords de cette marche ne sont pas nécessairement strictement perpendiculaires à la surface 2' du substrat 2. La marche est définie par, à la fois, le niveau inférieur défini par la surface supérieure de la couche 4, dans les zone où il n'y a pas de motif 3 sous jacent, et le niveau supérieur ou la partie surélevée de cette même couche 4.

On procède ensuite au dépôt de la couche 31 d'AlN, là encore par exemple par technique PVD, d'une part sur la surface de cette couche 4 dans ses parties non surélevées, mais aussi sur la surface de cette couche 4 dans la partie qui est surélevée du fait de la présence du motif 3.

Puis, on forme de nouveau une couche de masque 40, dont les flancs 20, 22 sont alignés - au sens et de la manière déjà expliqués ci-dessus - avec les flancs 13a, 13b de la couche 3 et les flancs 10a, 10b de la couche 4. Cet alignement va permettre de définir une extrémité haute 30₁, 32₁ et une extrémité basse 30₂, 32₂ des flancs 30, 32 qui vont être réalisés dans la couche 31.

Les bords du masque 40 vont définir les extrémités hautes 30₁, 32₁ des flancs à graver (autrement dit, ces extrémités hautes sont positionnées là où sont positionnés les bords du masque).

De même, les bords de la portion surélevée de la couche 4 vont définir les extrémités basses 30₂, 32₂ des flancs à graver (autrement dit, ces extrémités basses sont positionnées là où sont positionnés les bords de la portion surélevée de cette couche).

Cette couche de masque peut former une ou plusieurs électrodes.

On procède ensuite (figure 2B) à une gravure de la couche 31, ce qui conduit à la formation de flancs 30, 32 de cette couche 31. Ces flancs sont perpendiculaires à la surface 3' de la couche 3 ou à la surface 4' de la couche 4 du fait de l'alignement qui vient d'être évoqué.

La pente de chaque flanc, qui s'étend entre une extrémité haute 30₁, 32₁ et une extrémité basse 30₂, 32₂ est définie par le couple correspondant d'extrémité haute et basse 30₁, 32₁ et 30₂, 32₂.

Dans ce deuxième mode de réalisation, les épaisseurs et les matériaux pour les couches 4, 31, 40, peuvent être identiques ou similaires aux épaisseurs et matériaux indiqués ci-dessus, dans le cadre du premier mode de réalisation. Quant à la couche 3, elle peut être par exemple en dioxyde de silicium (SiO₂), ou en nitrure de silicium (SiN), ou en molybdène (Mo), ou en platine (Pt) et avoir une épaisseur qui peut être comprise, comme la sous-couche 4, entre 10 nm et 1 µm.

Selon ce deuxième mode de réalisation, on ne grave pas nécessairement la sous couche 4, mais on crée une topologie, ou une marche, ou un relief, à la surface de cette sous-couche 4 par la formation, antérieurement, d'une couche sous jacente 3 présentant des flancs qui se traduiront, lors du dépôt de la sous-couche 4, également par des flancs 10a, 10b.

On procède ensuite à la gravure de la couche 31, dans les zones non situées sous la couche 40 de masque. Comme précédemment, on grave la couche 31 sur toute son épaisseur, mais on met alors à jour la surface 4' de la sous-couche 4.

On obtient donc une portion 31a en AlN, avec des flancs latéraux 30, 32, dont on constate, là encore, qu'ils sont perpendiculaires à la surface horizontale définie ici par la surface supérieure 4' de la sous-couche 4.

Autrement dit, il est possible d'utiliser la couche 3 pour former une topologie ou un relief dans la sous-couche 4 dont les bords 10a, 10b, vont, à leur tour, permettre d'aligner les bords de la couche 40 de masque, et de définir les zones dans lesquelles des flancs verticaux de la couche 31 seront obtenus, après gravure.

Dans ce deuxième mode de réalisation on peut aussi réaliser un ou des trous comme le trou 60 de la figure 1D, avec des flancs verticaux et avec les caractéristiques géométriques déjà mentionnées ci-dessus. On peut par exemple, pour cela, configurer la forme de la topologie de la sous-couche 4 et la forme du masque 40, comme en figure 1C. On peut, à cette fin, graver la sous-couche 4 après son dépôt sur le substrat 2 et sur la couche 3, puis, après dépôt de la couche 31 d'AlN, réaliser un masque 40 qui présente lui aussi des zones gravées, alignés avec la zone gravée de la sous-couche 4. On peut en outre réaliser, là aussi, un ou plusieurs flancs inclinés, comme le flanc 36 de la figure 1D.

Il est possible, comme illustré en figure 4, de combiner les deux modes de réalisation. On peut donc réaliser une première partie 31a de la couche d'AlN sur une topologie obtenue à partir d'une couche telle que la couche 3, et réaliser une deuxième partie 31b de la couche d'AIN à l'aide d'une topologie obtenue par gravure de la partie de la sous-couche 4 déposée directement sur la surface 2' du substrat 2. On peut par exemple réaliser un trou 60' dans cette deuxième partie grâce à une gravure préalable de cette sous-couche 4. La pente de chaque flanc s'étend entre une extrémité haute 30₁, 32₁, 34₁ et une extrémité basse 30₂, 32₂, 34₂ et est définie par le couple correspondant d'extrémité haute et basse 30₁, 32₁, 34₁ et 30₂, 32₂, 34₂.

Encore un autre mode de réalisation de l'invention va être décrit en liaison avec les figures 5A à 5D.

On réalise en surface d'un substrat 2, par exemple en silicium ou en saphir, une topologie, donc une surface présentant des variations d'altitude. Des parties 4a, 4'a sont donc surélevées (niveau supérieur) par rapport au reste de la surface 2', qui forme le niveau inférieur. Ces parties présentent des bords 10, 12, 14 sensiblement perpendiculaires à cette surface 2'. En variante, on peut avoir une seule partie surélevée, par exemple la partie 4'a de la figure 5A. Autrement dit, la partie surélevée peut être continue ou connexe. Ces portions 4a, 4'a peuvent être obtenues par gravure d'un substrat 2 initialement uniformément plan, elles peuvent donc être en même matériau que le substrat 2.

On procède ensuite (figure 5B) au dépôt d'une couche 31 d'AIN, qui peut avoir les mêmes caractéristiques, notamment d'épaisseur, que celles déjà indiqué ci-dessus, par exemple en liaison avec les figures 1A - 1D. Les mêmes techniques de dépôts que celles déjà indiquées ci-dessus peuvent être utilisés. Le dépôt est réalisé à la fois sur le niveau inférieur défini par la surface 2' et sur le niveau supérieur ou sur la partie surélevée de la topologie 4a, 4'a.

Cette couche 31 est déposée uniformément sur les portions surélevées 4a, 4a' du substrat, ainsi que sur les autres parties de la surface 2' du substrat 2 qui sont à un niveau inférieur.

On procède ensuite (figure 5C) sur la couche 31 à une étape de réalisation d'un masque dur 40, 40', dont les bords 20, 22, 24 sont alignés avec les bords 10, 12, 14 des zones 4a, 4'a. Une ou plusieurs parties de ce masque peut former une électrode, par exemple d'un dispositif non représenté sur les figures.

Cet alignement va permettre de définir une extrémité haute 30₁, 32₁, 34₁ et une extrémité basse 30₂, 32₂, 34₂ des flancs 30, 32, 34 qui vont être réalisés dans la couche 31.

Les bords du masque 40, 40' vont définir les extrémités hautes 30₁, 32₁, 34₁ des flancs à graver (autrement dit, ces extrémités hautes sont positionnées là où sont positionnés les bords du masque).

De même, les bords des portions surélevées 4a, 4' a vont définir les extrémités basses 30₂, 32₂, 34₂ des flancs à graver (autrement dit, ces extrémités basses sont positionnées là où sont positionnés les bords de ces portions surélevées).

Autrement dit, ces bords 20, 22, 24 définissent avec, respectivement, chacun des bords 10, 12, 14 un plan qui est sensiblement perpendiculaire à la surface 2' du substrat 2. En fait, là encore, ce plan pourra ne pas être strictement perpendiculaire à la surface 2', mais être légèrement incliné par rapport à la direction perpendiculaire, par exemple d'un angle compris entre 0° et 15°. Cette couche de masque 40, 40' a une épaisseur qui peut être comprise par exemple entre 10 nm et 10 µm. Elle peut être par exemple en molybdène Mo ou en nitrure de silicium (SiN, Si₃N₄).

Seul l'un des flancs représentés, le flanc droit 26 du masque 40 n'est, lui, pas aligné avec le flanc droit 16 de la zone 4a de topologie.

On procède ensuite à une étape de gravure, comme représenté en figure 5D. Cette étape va permettre de graver la couche 31 de matériau AlN, dans des zones qui ne sont pas protégées par le masque 40, 40'. Cette gravure est poursuivie jusqu'à la surface 2' du substrat 2, cette surface 2' réapparaît donc après que la gravure soit terminée.

La pente de chaque flanc, qui s'étend entre une extrémité haute 30₁, 32₁, 34₁ et une extrémité basse 30₂, 32₂, 34₂ est définie par le couple correspondant d'extrémité haute et basse 30₁, 32₁, 34₁ et 30₂, 32₂, 34₂.

Du fait des conditions d'alignement des bords du masque 40, 40' avec ceux de la topologie 4a, 4'a, on obtient des flancs 30, 32, 34, de la couche 31, alignés avec les flancs correspondant de la topologie 4a, 4'a et de la couche de masque 40, 40'.

Autrement dit, ces flancs 30, 32, 34 de la couche d'AlN 31 sont perpendiculaires à la surface 2' du substrat 2, ou leur inclinaison par rapport à cette perpendiculaire est inférieure à quelques degrés, par exemple inférieure à ±15°.

Dans l'exemple illustré, la gravure conduit à la formation d'un trou 60, entre deux portions 31a, 31b d'AlN qui sont situées sous les portions 40, 40' de masque dur.

Les parois de ce trou sont les flancs 32, 34 qui, comme indiqué ci-dessus, sont perpendiculaires à la surface 2' de la couche 2. Avec cette technique, il est possible d'obtenir un trou de diamètre 0 d'environ 10µm, plus généralement compris entre 100 nm et 100 µm et/ou un trou qui traverse la couche 31, et dont le rapport du diamètre Ø à l'épaisseur H de la couche est inférieur ou égal à environ 1/2.

Comme déjà indiqué ci-dessus, le flanc droit 26 de la couche de masque 40 n'est pas aligné avec le flanc droit 16 de la couche 4 de croissance.

Il en résulte donc un flanc 36 de la couche 31b qui n'est pas perpendiculaire à la surface 2' de substrat 2, mais définit, avec cette surface 2', un angle α.

Selon encore un autre exemple de réalisation de l'invention, qui va être décrit en liaison avec les figures 6A à 6D, on réalise en surface d'un substrat 2, une topologie avec une surface qui présente une marche 10, celle-ci délimitant une partie 4b surélevée par rapport au reste de la surface 2'. Cette configuration peut résulter de la gravure d'un substrat initialement uniformément plan.

Puis on procède comme décrit ci-dessus : dépôt d'une couche d'AlN 31 (figure 6B), formation d'une couche de masque 40 (figure 6C) dont le bord 20 est aligné avec le bord 10 et gravure (figure 6D).

Du fait de la condition d'alignement du bord 20 du masque 40 (qui peut être une électrode) avec celui de la topologie 4'b, on obtient un flanc 30 de la couche 31, aligné avec le flanc correspondant de la sous-couche 4'b et de la couche de masque 40.

Autrement dit, ce flanc 30 de la couche d'AlN 31 est perpendiculaire à la surface 2' du substrat 2, ou son inclinaison par rapport à cette perpendiculaire est inférieure à quelques degrés, par exemple inférieure à ±15°.

La pente de chaque flanc, qui s'étend entre une extrémité haute 30₁ et une extrémité basse 30₂ est définie par le couple correspondant d'extrémité haute et basse 30₁ et 30₂. Ces extrémités sont elles mêmes définies par le bord de la zone supérieure de la marche et par le bord de la couche 40 de masque.

Dans les deux modes de réalisation des figures 5A - 5D et 6A - 6D :
- la surface supérieure des portions 4a, 4' a, 4b peut être surélevée, par rapport à la surface 2', d'une hauteur ou d'une épaisseur de l'ordre de 200 nm, ou, plus généralement, comprise entre 10 nm et 1 µm ou encore entre 100 nm et 300 nm,
- la référence 7 désigne une éventuelle couche 7 de texturation ou de germination, ayant la même fonction que dans les exemples précédents,
- la nature et/ou l'épaisseur de la couche de masque 40, 40' peut être celle des exemples précédents,
- les techniques de dépôts, de gravure et d'alignement peuvent être les mêmes que dans les exemples précédents.

Dans un procédé ou un dispositif selon l'invention, les flancs droits 30, 32, 34 de la couche d'AlN sont définis par les bords des sous-couches 4, 4' de croissance ou de la topologie 4a, 4'a, 4b formée en surface du substrat 2.

La topologie ou le relief peut être obtenue par gravure de cette même couche (cas des figures 1A-1D), ou par croissance de cette couche sur une topologie préexistante (cas des figures 2A et 2B), ou par gravure du substrat 2 (cas des figures 5A - 6D).

L'angle réel des flancs 30, 32, 34 de la couche d'AlN est obtenu par la précision d'alignement des flancs de la ou des sous-couches 4, 4' et des bords du ou des masques 40, 40'. La pente de chaque flanc 30, 32, 34 est définie par un bord du masque dur 40, 40' et un bord de la sous-couche 4, 4' de croissance ou de la topologie 4a, 4'a, 4b.

Ces exemples de réalisation montrent en outre que, dans un même dispositif, on peut obtenir des portions présentant des flancs droits 30, 32, 34, et une ou des portions présentant un ou des flancs inclinés tel que le flanc 36.

Dans tous les exemples présentés ci-dessus :
- la gravure utilisée pour la couche 31 est une gravure humide, par exemple au H₃PO₄ chaud (à température sensiblement comprise entre 100°C et 140°C),
- et/ou le substrat initial 2 peut être un substrat hétérogène, par exemple de types multicouche, ou bien de type homogène ou massif (ou « bulk»).

Tout ou partie des portions de masque 40, 40' peut être éliminée après gravure de la couche d'AlN.

Quel que soit le mode de réalisation retenu, la technique présentée ci-dessus permet d'obtenir des flancs droits dans une couche d'AlN, sans surgravure.

Elle permet en outre d'obtenir des gravures de petites dimensions latérales, avec des « gap » fins, et/ou de faire un ou des trous droits 60 avec des petites dimensions, c'est-à-dire de réaliser des vias.

## Revendications

1. Procédé de réalisation d'une couche d'AIN à flancs sensiblement verticaux par rapport à une surface (4', 2') d'un substrat (2), chaque flanc s'étendant entre une extrémité basse et une extrémité haute, la surface dudit substrat présentant une topologie (4, 4', 4a, 4'a, 4b), comportant au moins un motif de type marche (10, 12, 14, 16), ce procédé comportant :
- le dépôt de la couche d'AIN (31), au moins sur ledit motif de la topologie, l'extrémité du haut de la marche correspondant à l'extrémité basse dudit flanc,
- la formation, par dessus la couche d'AIN, d'une couche (40, 40') de masque, dont au moins un bord est positionné de façon à définir l'extrémité haute du flanc,
- la gravure de la couche d'AIN (31) à travers le masque, la gravure de la couche d'AIN étant de type gravure humide, pour obtenir ledit flanc, la pente du flanc étant définie par la position desdites extrémités haute et basse dont l'inclinaison forme un angle au plus égal à 15° par rapport à la perpendiculaire à la surface (4', 2') du substrat (2).

2. Procédé selon la revendication 1, comportant une étape préalable de formation de la topologie (4a, 4'a, 4b) du substrat, par gravure de la surface (4', 2') du substrat (2), de manière à obtenir au moins le motif de type marche.

3. Procédé selon l'une de revendications 1 ou 2, la marche présentant au moins un flanc latéral (10, 12, 14, 16) formant un angle au plus égal à 15° par rapport à la perpendiculaire à la surface (4', 2') du substrat (2) dans ou sur lequel elle est réalisée.

4. Procédé selon l'une des revendications 1 à 3, dans lequel le substrat comporte une sous-couche (4, 4'), dont une surface forme, avec la surface du substrat, le motif de type marche.

5. Procédé selon la revendication 4, la sous-couche (4, 4') étant obtenue :
- par dépôt d'une couche uniforme de matériau, puis gravure au moins de cette couche, pour obtenir le motif de type marche ;
- ou par dépôt sur une couche (3) formant une topologie en surface (2') de substrat (2).

6. Procédé selon l'une des revendications 4 ou 5, au moins une partie de la sous-couche (4, 4') formant une électrode.

7. Procédé selon l'une des revendications précédentes, au moins une partie de la couche de masque (40, 40') formant une électrode.

8. Procédé selon l'une des revendications précédentes, la couche de masque (40, 40') étant en silice (SiO₂), ou en molybdène (Mo), ou en platine (Pt) ou en une résine adhérente.

9. Procédé selon l'une des revendications précédentes, comportant en plus la réalisation d'un flanc incliné (36) par gravure de la couche d'AIN (39).

10. Procédé selon l'une des revendications précédentes, comportant en outre la réalisation d'un trou (60) à bords verticaux.

## Patentansprüche

1. Verfahren zur Herstellung einer AlN-Schicht mit Flanken, die im Wesentlichen vertikal bezüglich einer Oberfläche (4', 2') eines Substrats (2) sind, wobei sich jede Flanke zwischen einem unteren Ende und einem oberen Ende erstreckt, wobei die Oberfläche des Substrats eine Topologie (4, 4', 4a, 4'a, 4b) aufweist, die wenigstens ein stufenförmiges Motiv (10, 12, 14, 16) umfasst, wobei dieses Verfahren umfasst:
- Aufbringen der AlN-Schicht (31) wenigstens auf das Motiv der Topologie, wobei das obere Ende der Stufe dem unteren Ende der Flanke entspricht,
- Bilden, von oberhalb der AlN-Schicht, einer Maskenschicht (40, 40'), von der wenigstens ein Rand derart positioniert ist, dass das obere Ende der Flanke definiert wird,
- Ätzen der AlN-Schicht (31) durch die Maske hindurch, wobei das Ätzen der AlN-Schicht vom Typ Nassätzen ist, um die Flanke zu erhalten, wobei die Steilheit der Flanke durch die Position des oberen und des unteren Endes, deren Neigung einen Winkel von höchstens gleich 15° bezüglich der Normalen zur Oberfläche (4', 2') des Substrats (2) bildet.

2. Verfahren nach Anspruch 1, umfassend einen vorherigen Schritt des Bildens der Topologie (4a, 4'a, 4b) des Substrats durch Ätzen der Oberfläche (4', 2') des Substrats (2) derart, dass wenigstens das stufenförmige Motiv erhalten wird.

3. Verfahren nach einem der Ansprüche 1 oder 2, wobei die Stufe wenigstens eine laterale Flanke (10, 12, 14, 16) aufweist, die einen Winkel von höchstens gleich 15° bezüglich der Normalen zur Oberfläche (4', 2') des Substrats (2) bildet, in oder auf der sie realisiert ist.

4. Verfahren nach einem der Ansprüche 1 bis 3, bei dem das Substrat eine Teilschicht (4, 4') umfasst, von der eine Oberfläche zusammen mit der Oberfläche des Substrats das stufenförmige Motiv bildet.

5. Verfahren nach Anspruch 4, wobei die Teilschicht (4, 4') erhalten wird:
- durch Aufbringen einer gleichförmigen Materialschicht und anschließendes Ätzen wenigstens dieser Schicht, um das stufenförmige Motiv zu erhalten;
- oder durch Aufbringen auf einer Schicht (3), die eine Topologie an der Oberfläche (2') des Substrats (2) bildet.

6. Verfahren nach einem der Ansprüche 4 oder 5, wobei wenigstens ein Teil der Teilschicht (4, 4') eine Elektrode bildet.

7. Verfahren nach einem der vorhergehenden Ansprüche, wobei wenigstens ein Teil der Maskenschicht (40, 40') eine Elektrode bildet.

8. Verfahren nach einem der vorhergehenden Ansprüche, wobei die Maskenschicht (40, 40') aus Siliziumdioxid (SiO₂), oder aus Molybdän (Mo), oder aus Platin (Pt) oder aus einem haftenden Harz ist.

9. Verfahren nach einem der vorhergehenden Ansprüche, ferner umfassend die Realisierung einer geneigten Flanke (36) durch Ätzen der AlN-Schicht (39).

10. Verfahren nach einem der vorhergehenden Ansprüche, ferner umfassend die Realisierung eines Lochs (60) mit vertikalen Rändern.

## Claims

1. Method for producing a layer of AlN having at least one side which is substantially vertical or perpendicular relative to a surface (4', 2') of a substrate (2), each side extending between a bottom end and a top end, the surface of said substrate having a topology (4, 4', 4a, 4' a, 4b) comprising at least one step-type pattern (10, 12, 14, 16), said method comprising:
- the deposition of the AlN layer (31), on at least said pattern of the topology, the top end of the step corresponding to the bottom end of said side,
- the formation of a mask layer (40, 40') over the AlN layer, at least one edge of which is positioned so as to define the top end of the side,
- the etching of the AlN layer (31) through the mask, in order to obtain said side, the slope of the side being defined by the position of said top and bottom edges, the inclination of which forming an angle equal to at most 15° relative to the perpendicular to the surface (4' , 2') of the substrate (2).

2. Method according to claim 1, comprising a preliminary step for forming the topology (4a, 4'a, 4b) of the substrate, by etching the surface (2') of the substrate (2), so as to at least obtain the step-type pattern.

3. Method according to one of claims 1 or 2, the step having at least one lateral side (10, 12, 14, 16) forming an angle equal to at most 15° relative to the perpendicular to the surface (4', 2') of the substrate (2) in or on which same is made.

4. Method according to one of claims 1 to 3, wherein the substrate comprises a sub-layer (4, 4'), one surface of which, together with the surface of the substrate, forms the step-type pattern.

5. Method according to claim 4, the sub-layer (4, 4') being obtained:
- by depositing a uniform layer of material, and by then etching at least said layer, in order to obtain the step-type pattern;
- or by depositing on a layer (3) forming a topology on the surface (2') of the substrate (2).

6. Method according to one of claims 4 or 5, at a least a portion of the sub-layer (4, 4') forming an electrode.

7. Method according to one of the preceding claims, at least a portion of the mask layer (40, 40') forming an electrode.

8. Method according to one of the preceding claims, the mask layer (40, 40') being made of silica (SiO₂), or molybdenum (Mo), or platinum (Pt) or an adhesive resin.

9. Method according to one of the preceding claims, further comprising the production of an inclined side (36) by etching the AlN layer (39).

10. Method according to one of the preceding claims, further comprising the production of a hole (60) having vertical edges.
